# FASCICULE DE BREVET EUROPEEN

(11) **EP 3 151 290 B1**
(45) Date de publication et mention de la délivrance du brevet: **01.11.2017**
(21) Numéro de dépôt: 16189323.5
(22) Date de dépôt: 16.09.2016
(51) Int. Cl.: H01L 31/107

(54) **PHOTODIODE DE TYPE SPAD**
SPAD-PHOTODIODE
SPAD PHOTODIODE

(30) Priorité: 30.09.2015 FR 1559237
(43) Date de publication de la demande: 05.04.2017
(73) Titulaire: COMMISSARIAT À L'ÉNERGIE ATOMIQUE ET AUX ÉNERGIES ALTERNATIVES, 75015 Paris (FR)
(72) Inventeur: MOUSSY, Norbert, 38190 SAINTE AGNES (FR); OUVRIER-BUFFET, Jean-Louis, 74320 SEVRIER (FR)
(74) Mandataire: Thibon, Laurent

(56) Documents cités:
- US-A1- 2011 095 388
- US-A1- 2015 054 111
- US-B1- 8 093 624

## Description

### Domaine

La présente demande concerne le domaine des photodiodes à avalanche pour la détection de photons uniques, aussi appelées photodiodes SPAD (de l'anglais "Single Photon Avalanche Diode").

### Exposé de l'art antérieur

Une photodiode SPAD est essentiellement constituée par une jonction PN polarisée en inverse à une tension supérieure à son seuil d'avalanche. Lorsqu'aucune charge électrique n'est présente dans la zone de déplétion ou zone de charge d'espace de la jonction PN, la photodiode est dans un état pseudo-stable, non conducteur. Lorsqu'une charge électrique photogénérée est injectée dans la zone de déplétion, si la vitesse de déplacement de cette charge dans la zone de déplétion est suffisamment élevée, c'est-à-dire si le champ électrique dans la zone de déplétion est suffisamment intense, la photodiode est susceptible d'entrer en avalanche. Un seul photon est ainsi capable de générer un signal électrique mesurable, et ce avec un temps de réponse très court. Les photodiodes SPAD permettent de détecter des rayonnements de très faible intensité lumineuse, et sont notamment utilisées pour la détection de photons uniques et le comptage de photons.

Le document US2015/054111 divulgue une photodiode de type SPAD selon l'état de la technique. Il serait souhaitable de pouvoir améliorer au moins en partie certains aspects des photodiodes SPAD connues.

### Résumé

Ainsi, un mode de réalisation prévoit une photodiode de type SPAD comportant, dans un substrat semiconducteur d'un premier type de conductivité : une première région du deuxième type de conductivité s'étendant depuis la face supérieure du substrat ; une deuxième région du premier type de conductivité de niveau de dopage supérieur à celui du substrat, s'étendant depuis la face inférieure de la première région, la deuxième région ayant, en vue de dessus, une surface inférieure à celle de la première région et étant située en regard d'une partie centrale de la première région ; une troisième région du premier type de conductivité de niveau de dopage supérieur à celui du substrat s'étendant depuis la face supérieure du substrat, la troisième région entourant latéralement la première région ; et une quatrième région enterrée du premier type de conductivité de niveau de dopage supérieur à celui du substrat, formant un anneau périphérique reliant la deuxième région à la troisième région de façon que les faces latérales et la face inférieure de la première région soient entièrement entourées par l'ensemble formé par les deuxième, troisième et quatrième régions.

Selon un mode de réalisation, le niveau de dopage du substrat est inférieur à 5*10¹⁴ atomes/cm³.

Selon un mode de réalisation, le niveau de dopage de la troisième région est supérieur ou égal à celui la deuxième région.

Selon un mode de réalisation, les épaisseurs E105 et E203 des deuxième et quatrième régions, et les niveaux de dopage C105 et C203 des deuxième et quatrième régions sont tels que le produit E105*C105 soit sensiblement égal au produit E203*C203.

Selon un mode de réalisation, les troisième et quatrième régions ne sont pas en contact avec la première région.

Selon un mode de réalisation, la troisième région est une région implantée ou diffusée formée dans le substrat.

Selon un mode de réalisation, la troisième région est une tranchée remplie de silicium polycristallin dopé.

Selon un mode de réalisation, une région de même type de conductivité que le substrat mais de niveau de dopage supérieur s'étend dans le substrat depuis les parois latérales de la tranchée.

Selon un mode de réalisation, la photodiode comprend en outre, du côté de la face arrière du substrat, une couche de même type de conductivité que le substrat mais de niveau de dopage supérieur.

Selon un mode de réalisation, la photodiode comprend en outre un circuit d'application d'une tension de polarisation entre les première et deuxième régions, cette tension étant supérieure à la tension d'avalanche de la photodiode et étant telle que la zone d'avalanche de la photodiode soit localisée en regard de la partie centrale de la première région et ne s'étende pas en regard de la partie périphérique de la première région.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est une vue en coupe schématique et partielle d'un exemple de photodiode SPAD ;
la figure 2 est une vue en coupe schématique et partielle d'un exemple d'un mode de réalisation d'une photodiode SPAD ; et
la figure 3 est une vue en coupe schématique et partielle d'un autre exemple d'un mode de réalisation d'une photodiode SPAD.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. En particulier, une photodiode SPAD comprend généralement des circuits annexes, notamment un circuit de polarisation de sa jonction PN à une tension supérieure à son seuil d'avalanche, ainsi qu'un circuit d'extinction ("quenching circuit" en anglais) ayant pour fonction d'interrompre l'avalanche de la photodiode une fois celle-ci déclenchée. Ces circuits annexes n'ont pas été représentés sur les figures et ne seront pas détaillés, les modes de réalisation décrits étant compatibles avec les circuits annexes équipant les photodiodes SPAD connues. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", "latéral", etc., il est fait référence à l'orientation des figures, étant entendu que, dans la pratique, les photodiodes décrites peuvent être orientées différemment. Sauf précision contraire, les expressions "approximativement", "sensiblement", et "de l'ordre de" signifient à 10 % près, de préférence à 5 % près, ou, lorsqu'elles concernent des angles ou des orientations angulaires absolues ou relatives, à 10 degrés près, et de préférence à 5 degrés près.

Un problème qui se pose dans les photodiodes SPAD connues est celui de la collecte des charges photogénérées en profondeur dans le substrat, à une distance éloignée de la zone d'avalanche de la photodiode, c'est-à-dire la partie de la zone de déplétion de la photodiode dans laquelle le champ électrique est suffisamment intense pour que l'avalanche puisse être déclenchée par une charge unique. En effet, au-delà d'une certaine distance de la jonction PN, le champ électrique résultant de la polarisation en inverse de la jonction PN s'annule ou s'atténue fortement, et ne permet plus d'entrainer les charges photogénérées vers la zone d'avalanche. Seule la diffusion aléatoire dans le substrat est alors susceptible de conduire les charges photogénérées vers la zone d'avalanche, avec une probabilité non négligeable que les charges photogénérées n'atteignent jamais la zone d'avalanche ou l'atteignent avec un retard important. Ce problème se pose notamment lorsque l'on souhaite collecter des charges photogénérées sous l'effet d'un rayonnement lumineux de longueur d'onde élevée, par exemple un rayonnement de longueur d'onde comprise entre 750 et 3000 nm.

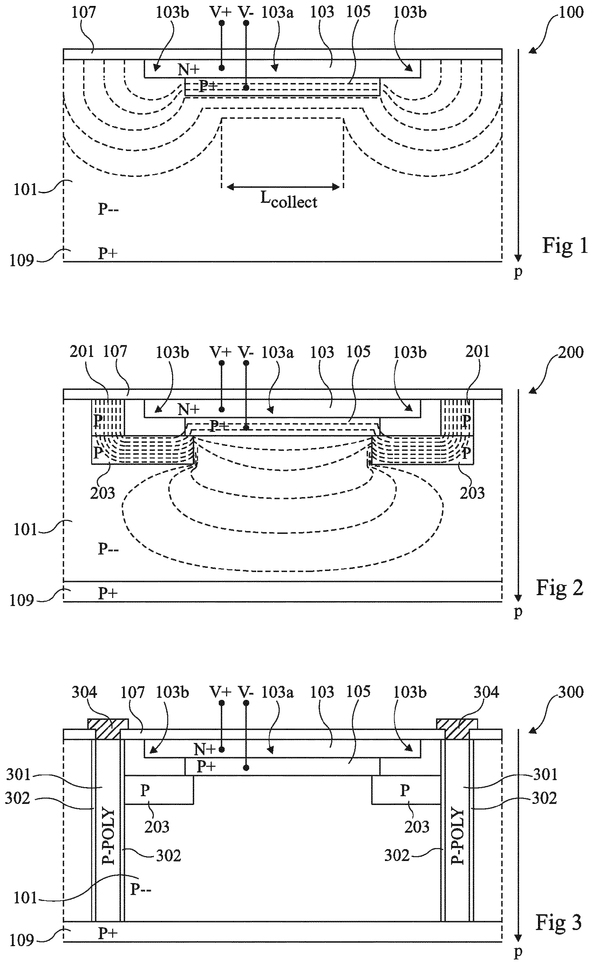

La figure 1 est une vue en coupe schématique et partielle d'un exemple de photodiode SPAD 100. La photodiode 100 comprend un substrat semiconducteur 101, par exemple en silicium. Dans l'exemple représenté, le substrat 101 est dopé de type P. La photodiode 101 comprend en outre, dans une partie supérieure du substrat 101, une région dopée de type N 103 s'étendant depuis la face supérieure du substrat, et, sous la région 103, une région dopée de type P 105, de niveau de dopage supérieur à celui du substrat 101, s'étendant depuis la face inférieure de la région 103. A titre d'exemple, la région 103 a une épaisseur comprise entre 50 et 250 nm, et la région 105 a une épaisseur comprise entre 100 et 500 nm. La région 105 présente, en vue de dessus, une surface inférieure à celle de la région 103, et est située en regard d'une partie centrale 103a de la région 103. Une région périphérique en anneau 103b de la région 103 s'étend donc latéralement au-delà de la périphérie de la région 105. A titre d'exemple, la largeur de la région périphérique 103b est comprise entre 0,1 et 2 µm. Dans l'exemple représenté, la face inférieure et la face latérale de la région périphérique 103b de la région 103 sont en contact avec le substrat 101. La région centrale 103a de la région 103 a sa face inférieure en contact avec la face supérieure de la région 105. Ainsi, la jonction PN de la photodiode 100 comprend une partie centrale formée entre la région 105 et la partie centrale 103a de la région 103, et une partie périphérique formée entre le substrat 101 et la partie périphérique 103b de la région 103. En vue de dessus (non représentée), les régions 103 et 105 sont par exemple de forme circulaire. Les modes de réalisation décrits ne se limitent toutefois pas à ce cas particulier. Dans l'exemple représenté, la photodiode 100 comprend en outre une couche de passivation 107, par exemple en oxyde de silicium, revêtant la face supérieure du substrat 101. Dans l'exemple représenté, la couche de passivation 107 revêt toute la surface de la photodiode. La couche de passivation 107 peut comprendre des ouvertures (non représentées) en regard de régions de prise de contact (non représentées) pour la polarisation du substrat 101. Des métallisations de contact peuvent alors être formées dans ces ouvertures. Dans cet exemple, la photodiode 100 comprend en outre, dans une partie inférieure du substrat 101, une région dopée de type P 109, de niveau de dopage supérieur à celui du substrat, s'étendant dans le substrat 101 depuis sa face inférieure. A titre d'exemple, la couche 109 peut être un substrat de départ, par exemple de 700 à 850 µm d'épaisseur, sur la face supérieure duquel est formée, par épitaxie, le substrat 101. A titre de variante, la couche 109 peut être la couche supérieure de silicium monocristallin d'un empilement de type silicium sur isolant (SOI), sur la face supérieure de laquelle est formée, par épitaxie, le substrat 101. La couche 109 s'étend par exemple sur sensiblement toute la surface du substrat 101. L'épaisseur de substrat 101 située sous la région 105, c'est-à-dire entre la face inférieure de la région 105 et la face supérieure de la couche 109 dans l'exemple représenté, est par exemple comprise entre 1 et 20 µm.

En fonctionnement, la région 103, formant la cathode de la photodiode, est polarisée à un potentiel positif V+, et la région 105, formant l'anode de la photodiode, est polarisée à un potentiel négatif V-, de façon que la tension cathode-anode de la photodiode soit supérieure à sa tension d'avalanche. Par souci de simplification, les bornes de contact permettant de polariser la photodiode n'ont pas été représentées. A titre d'exemple, l'anode de la photodiode est polarisée par l'intermédiaire de la région 109, ou par l'intermédiaire d'une région de contact non représentée située du côté de la face supérieure du substrat 101, dans une région périphérique du substrat 101.

Lorsque la photodiode 100 est polarisée en inverse, un champ électrique apparaît au niveau de la jonction PN de la photodiode. Sur la figure 1, on a représenté en traits interrompus les lignes équipotentielles dans le substrat 101 lorsque la photodiode 100 est polarisée en inverse. Le champ électrique (non représenté) dans la photodiode est sensiblement orthogonal aux lignes équipotentielles, et est d'autant plus intense que les lignes équipotentielles sont rapprochées. La zone de charge d'espace de la jonction PN, et le champ électrique résultant de la polarisation en inverse de la jonction PN, s'étendent d'autant plus profondément dans le substrat 101 que la tension de polarisation en inverse de la photodiode est élevée, et que les niveaux de dopage rencontrés sont faibles. Pour une tension de polarisation donnée, le champ électrique généré au niveau de la jonction PN est d'autant plus intense que les niveaux de dopage des régions de type P et N formant la jonction sont élevés.

Les niveaux de dopage des régions 103 et 105 et du substrat 101 et la tension de polarisation de la photodiode sont par exemple choisis de façon que le champ électrique au niveau de la partie centrale de la jonction PN (à l'interface entre la région 105 et la partie centrale 103a de la région 103) soit suffisamment intense pour que l'avalanche puisse être déclenchée par une charge photogénérée unique, et de façon que le champ électrique au niveau de la partie périphérique de la jonction PN (à l'interface entre le substrat 101 et la partie périphérique 103b de la région 103) soit suffisamment faible pour que l'avalanche ne puisse pas être déclenchée par une charge photogénérée unique. Ceci permet de réduire les risques de déclenchement parasite de l'avalanche liés aux effets de bord à la périphérie de la jonction PN.

De préférence, pour permettre la collecte des charges photogénérées en profondeur dans le substrat 101, c'est-à-dire sous la région 105, le substrat 101 est faiblement dopé, par exemple de niveau de dopage inférieur à 5*10¹⁴ atomes/cm³. A titre d'exemple, le substrat 101 peut être un substrat semiconducteur non intentionnellement dopé, c'est-à-dire dont le dopage de type P résulte uniquement de sa contamination accidentelle par des impuretés lors de sa fabrication. Comme l'illustre la figure 1, il résulte du faible niveau de dopage du substrat 101 que le champ électrique généré par la polarisation en inverse de la photodiode s'étend en profondeur dans le substrat, à distance de la jonction PN de la photodiode. Sous l'effet de ce champ électrique, les charges photogénérées dans le substrat, en l'espèce des électrons, sont entraînées vers la jonction PN suivant une trajectoire parallèle au champ électrique. A titre de variante, l'extension du champ électrique dans l'épaisseur du substrat peut aussi être obtenue avec un substrat de niveau de dopage plus élevé, sous réserve d'augmenter significativement la tension de polarisation en inverse de la photodiode.

Comme l'illustre la figure 1, la zone de charge d'espace de la jonction PN et le champ électrique résultant de la polarisation en inverse de la jonction PN se développent plus profondément dans le substrat au niveau de la partie périphérique de la jonction PN, qu'au niveau de sa partie centrale (en raison du niveau de dopage relativement faible du substrat 101 par rapport à la région 105). Les lignes équipotentielles qui se développent dans le substrat autour de la périphérie de la jonction PN forment des protubérances arrondies dont la largeur (c'est-à-dire la dimension horizontale ou parallèle la face supérieure du substrat) augmente au fur et à mesure que l'on s'éloigne de la jonction PN. Au-delà d'une certaine profondeur (ou distance de la face supérieure du substrat), ces protubérances s'étendent partiellement sous la région 105 de la photodiode, c'est-à-dire sous la partie centrale de la jonction PN, correspondant à la zone d'avalanche de la photodiode. Le champ électrique correspondant à ces protubérances arrondies pointe vers la partie périphérique de la jonction PN, dans laquelle les charges collectées ne permettent pas de déclencher l'avalanche de la photodiode. Les charges photogénérées en profondeur dans le substrat 101 ne sont donc susceptibles de provoquer l'avalanche de la photodiode que si elles sont générées dans une partie centrale de largeur L_{collect} de la photodiode, la largeur L_{collect} étant inférieure ou égale à la largeur de la région 105, et la largeur L_{collect} étant d'autant plus faible que la profondeur p à laquelle la charge est générée dans le substrat est élevée.

Il serait souhaitable de pouvoir disposer d'une photodiode SPAD permettant de collecter des charges photogénérées en profondeur dans le substrat avec une plus grande efficacité que la structure de la figure 1.

La figure 2 est une vue en coupe schématique et partielle d'un exemple d'un mode de réalisation d'une photodiode SPAD 200. La photodiode SPAD 200 de la figure 2 comprend sensiblement les mêmes éléments que la photodiode SPAD 100 de la figure 1, agencés sensiblement de la même manière. Ces éléments ne seront pas décrits à nouveau ci-après.

La photodiode SPAD 200 comprend en outre une région de type P 201, de niveau de dopage supérieur à celui du substrat 101, s'étendant verticalement dans le substrat 101 depuis sa face supérieure, sur une profondeur supérieure à celle de la région 103, et formant un anneau périphérique entourant entièrement la région 103 en vue de dessus. A titre d'exemple, le niveau de dopage de la région 201 est intermédiaire entre le niveau de dopage du substrat et le niveau de dopage de la région 105. A titre de variante, le niveau de dopage de la région 201 est supérieur à celui de la région 105. Une distance non nulle sépare de préférence la région 103 de la région 201, par exemple une distance comprise entre 0,5 et 5 µm. Dans cet exemple, la région 201 s'étend jusqu'à une profondeur inférieure à l'épaisseur du substrat, par exemple jusqu'à une profondeur sensiblement égale à celle de la face inférieure de la région 105.

La photodiode 200 comprend de plus une région enterrée de type P 203, de niveau de dopage supérieur à celui du substrat 101, dont la face supérieure est située à une profondeur supérieure à celle de la région 103, par exemple à une profondeur supérieure ou égale à celle de la face inférieure de la région 105. La région 203 s'étend notamment sous la partie périphérique 103b de la région 103. La région 203 forme un anneau enterré reliant la région 201 à la région 105 tout le long de la périphérie de la jonction PN. Ainsi, les régions 201, 203 et 105 forment un caisson de séparation continu entourant entièrement les faces latérales et la face inférieure de la région 103, et s'interposant entre la région 103 et la partie inférieure du substrat. Le niveau de dopage de la région 203 est par exemple identique ou similaire à celui de la région 105. Dans cet exemple, la région 203 s'étend jusqu'à une profondeur inférieure à celle de la face inférieure du substrat. A titre d'exemple, l'épaisseur de la région 203 est comprise entre 200 et 600 nm. Si l'on désigne par E105 l'épaisseur de la région 105, par C105 la concentration moyenne d'éléments dopants dans la région 105, par E203 l'épaisseur de la région 203, et par C203 la concentration moyenne d'éléments dopants dans la région 203, les valeurs E105, C105, E203, C203 sont par exemple telles que le produit C203*E203 soit approximativement égal au produit C105*E105.

A titre d'exemple, la polarisation de la région d'anode de la photodiode peut être effectuée par l'intermédiaire des régions 201 et 203. Pour cela, une métallisation de connexion (non représentée) peut être disposée en contact avec la face supérieure de la région 201, dans une ouverture (non représentée) formée dans la couche de passivation 107.

Le fonctionnement de la photodiode 200 de la figure 2 est similaire à celui de la photodiode 100 de la figure 1.

Comme dans l'exemple de la figure 1, lorsque la photodiode 200 est polarisée en inverse, un champ électrique apparaît au niveau de la jonction PN de la photodiode. Sur la figure 2, on a représenté en traits interrompus les lignes équipotentielles dans le substrat 101 lorsque la photodiode 200 est polarisée en inverse.

Les niveaux de dopage des régions 101, 103, 105, 201 et 203, la distance entre la région 201 et la région 103, la distance entre la région 203 et la région 103, et la tension de polarisation de la photodiode, sont par exemple choisis de façon que le champ électrique au niveau de la partie centrale de la jonction PN (à l'interface entre la région 105 et la partie centrale 103a de la région 103) soit suffisamment intense pour que l'avalanche puisse être déclenchée par une charge photogénérée unique, par exemple soit supérieur à 300 kV/cm sur une épaisseur de 100 à 500 nm, et de façon que le champ électrique au niveau de la partie périphérique de la jonction PN (à l'interface entre le substrat 101 - dont le niveau de dopage peut avoir localement augmenté du fait de la réalisation de la région enterrée 203 - et la partie périphérique 103b de la région 103) soit suffisamment faible pour que l'avalanche ne puisse pas être déclenchée par une charge photogénérée unique, par exemple soit inférieur à 300 kV/cm. A titre d'exemple, la tension de claquage en inverse (ou tension d'avalanche) de la photodiode est comprise entre 10 et 50 V, et la tension de polarisation en inverse de la photodiode est supérieure à sa tension de claquage d'une valeur comprise entre 0,5 et 10 V.

Comme dans l'exemple de la figure 1, le substrat 101 de la photodiode 200 est de préférence faiblement dopé pour faciliter la collecte des charges photogénérées en profondeur dans le substrat. Comme illustré par les lignes équipotentielles tracées sur la figure 2, le champ électrique résultant de la polarisation en inverse de la partie périphérique de la jonction PN reste confiné dans les régions 201 et 203, et ne s'étend pas ou peu dans la partie inférieure du substrat 101 (i.e. dans la partie du substrat 101 située à l'extérieur du caisson de séparation formé par les régions 201, 203 et 105). En d'autres termes, dans le mode de réalisation de la figure 2, les lignes équipotentielles présentent, comme dans l'exemple de la figure 1, des protubérances arrondies autour de la partie périphérique de la jonction PN, mais ces protubérances restent confinées à l'intérieur des régions 201 et 203, et ne s'étendent pas sous la partie centrale de la photodiode. Le champ électrique résultant de la polarisation en inverse de la partie centrale de la jonction PN s'étend quant à lui en profondeur dans le substrat 101, sous la région 105. A partir d'une certaine profondeur p dans le substrat 101, correspondant sensiblement à la profondeur de la face inférieure de la région 203, les lignes de champ s'évasent, et un champ électrique pointant vers la zone d'avalanche de la photodiode se développe sous au moins une partie de la partie périphérique de la jonction PN. Ainsi, dans le mode de réalisation de la figure 2, la largeur de collecte des charges photogénérées dans le substrat est toujours au moins sensiblement égale à la largeur de la zone d'avalanche (c'est-à-dire sensiblement égale à la largeur de la région 105), et peut être supérieure à la largeur de la zone d'avalanche pour des charges photogénérées en profondeur dans le substrat 101. Plus particulièrement, du fait de la continuité du caisson de séparation formé par les régions 201 et 203, la structure de la figure 2 bénéficie d'un effet "lentille" qui la rend particulièrement adaptée à la collecte de charges photogénérées en profondeur dans le substrat 101.

A titre d'exemple, dans la structure de la figure 2, le niveau de dopage de la région 103 est compris entre 5*10¹⁷ et 5*10¹⁹ atomes/cm³, le niveau de dopage de la région 105 est compris entre 1*10¹⁶ et 5*10¹⁷ atomes/cm³, le niveau de dopage de la région 201 est compris entre 5*10¹⁷ et 5*10¹⁹ atomes/cm³, et le niveau de dopage de la région 203 est compris entre 1*10¹⁶ et 5*10¹⁷ atomes/cm³. La distance entre la région 103 et la région 201 et la distance entre la région 103 et la région 203 sont de préférence telles que la distance entre le contour de concentration en éléments dopants de type N à 10¹⁷ atomes/cm³ et le contour de concentration en éléments dopants de type P à 10¹⁷ atomes/cm³ est au minimum de 0,2 µm au niveau de la partie périphérique de la jonction PN.

La figure 3 est une vue en coupe schématique et partielle d'un autre exemple d'un mode de réalisation d'une photodiode SPAD 300. La photodiode SPAD 300 de la figure 3 comprend de nombreux éléments communs avec la photodiode SPAD 200 de la figure 2. Ces éléments communs ne seront pas décrits à nouveau. Dans la suite, seules les différences entre la structure de la figure 2 et la structure de la figure 3 seront détaillées.

La photodiode 300 de la figure 3 diffère de la photodiode 200 de la figure 2 essentiellement en ce que, dans l'exemple de la figure 3, une tranchée périphérique 301 remplie de silicium polycristallin dopé de type P est substituée à la région de substrat dopée de type P 201 de la structure de la figure 2. La tranchée 301 s'étend verticalement depuis la face supérieure du substrat jusqu'à une profondeur supérieure à celle de la région 103, et forme un anneau périphérique entourant entièrement la région 103 en vue de dessus. Dans l'exemple représenté, la tranchée 301 s'étend jusqu'à la couche 109, et débouche dans la couche 109. La tranchée 301 n'est pas isolée du substrat 101, c'est-à-dire que le silicium polycristallin dopé de type P remplissant la tranchée 301 est en contact avec le substrat 101 au niveau des parois de la tranchée 301. De préférence, une région 302 de niveau de dopage supérieur à celui du substrat 101, s'étend dans le substrat depuis les parois latérales de la tranchée 301. Pour former la région 302, on peut par exemple prévoir un recuit de la structure après remplissage de la tranchée par du silicium polycristallin dopé de type P, de manière à faire diffuser dans le substrat 101 des éléments dopants de type P en provenance du silicium polycristallin. La prévision de la région 302 permet d'éviter que les lignes de champ électrique n'atteignent les parois de la tranchée 301, ce qui pourrait attirer vers la zone d'avalanche des charges parasites générées à l'interface avec la tranchée 301. Le niveau de dopage du silicium polycristallin remplissant la tranchée 301 est supérieur à celui du substrat 101. Le niveau de dopage dans la tranchée 301 est par exemple supérieur à celui de la région 105. Une distance non nulle sépare de préférence la région 103 de la tranchée 301.

La photodiode 300 de la figure 3 comprend une région enterrée de type P 203 sensiblement identique à celle de la photodiode 200 de la figure 2, reliant la tranchée 301 à la région 105 tout le long de la périphérie de la jonction PN. Ainsi, les régions 301, 203 et 105 forment un caisson de séparation continu entourant entièrement les faces latérales et la face inférieure de la région 103, et s'interposant entre la région 103 et la partie inférieure du substrat.

Du fait de la continuité de la séparation entre la région 103 et la partie inférieure du substrat, la structure de la figure 3 permet d'obtenir, de façon identique ou similaire à ce qui a été décrit en relation avec la figure 2, une amélioration significative de l'efficacité de collecte des charges photogénérées en profondeur dans le substrat.

A titre d'exemple, comme cela a été représenté sur la figure 3, la polarisation de la région d'anode de la photodiode peut être effectuée par l'intermédiaire de la tranchée 301. Pour cela, une métallisation de connexion 304 peut être disposée en contact avec la face supérieure de la tranchée 301, dans une ouverture formée dans la couche de passivation 107.

Des modes de réalisation particuliers ont été décrits. Diverses variantes et modifications apparaîtront à l'homme de l'art. En particulier, les avantages décrits ci-dessus peuvent être obtenus en inversant tous les types de conductivité par rapport aux exemples décrits.

De plus, on notera que la couche inférieure 109 des exemples décrits, de même type de conductivité que le substrat mais de niveau de dopage supérieur, est optionnelle. La prévision de la couche 109 a pour avantage de limiter les risques d'injection, dans la zone d'avalanche, de charges parasites générées du côté de la face arrière du substrat. La couche 109 permet en outre, de fixer le potentiel de la face inférieure du substrat et d'assurer un bon déploiement du champ électrique dans toute l'épaisseur du substrat. La couche 109 peut toutefois être omise, notamment dans le cas d'une photodiode destinée à être éclairée par sa face supérieure.

## Revendications

1. Photodiode (200 ; 300) de type SPAD comportant, dans un substrat semiconducteur (101) d'un premier type de conductivité :
une première région (103) du deuxième type de conductivité s'étendant depuis la face supérieure du substrat ;
une deuxième région (105) du premier type de conductivité de niveau de dopage supérieur à celui du substrat, s'étendant depuis la face inférieure de la première région (103), la deuxième région (105) ayant, en vue de dessus, une surface inférieure à celle de la première région (103) et étant située en regard d'une partie centrale (103a) de la première région ;
une troisième région (201 ; 301) du premier type de conductivité de niveau de dopage supérieur à celui du substrat s'étendant depuis la face supérieure du substrat, la troisième (201 ; 301) région entourant latéralement la première région (103) ; et
une quatrième région (203) enterrée du premier type de conductivité de niveau de dopage supérieur à celui du substrat, formant un anneau périphérique reliant la deuxième région (105) à la troisième région (201 ; 301) de façon que les faces latérales et la face inférieure de la première région (103) soient entièrement entourées par l'ensemble formé par les deuxième, troisième et quatrième régions.

2. Photodiode (200 ; 300) selon la revendication 1, dans laquelle le niveau de dopage du substrat (101) est inférieur à 5*10¹⁴ atomes/cm³.

3. Photodiode (200 ; 300) selon la revendication 1 ou 2, dans laquelle le niveau de dopage de la troisième région (201 ; 301) est supérieur ou égal à celui de la deuxième région (105).

4. Photodiode (200 ; 300) selon l'une quelconque des revendications 1 à 3, dans laquelle les épaisseurs E105 et E203 des deuxième (105) et quatrième (203) régions, et les niveaux de dopage C105 et C203 des deuxième (105) et quatrième (203) régions sont tels que le produit E105*C105 soit sensiblement égal au produit E203*C203.

5. Photodiode (200 ; 300) selon l'une quelconque des revendications 1 à 4, dans laquelle les troisième (201 ; 301) et quatrième (203) régions ne sont pas en contact avec la première région (103).

6. Photodiode (200) selon l'une quelconque des revendications 1 à 5, dans laquelle la troisième région (201) est une région implantée ou diffusée formée dans le substrat (101).

7. Photodiode (300) selon l'une quelconque des revendications 1 à 5, dans laquelle la troisième région (301) est une tranchée remplie de silicium polycristallin dopé.

8. Photodiode (300) selon la revendication 7, dans laquelle une région (302) de même type de conductivité que le substrat (101) mais de niveau de dopage supérieur s'étend dans le substrat (101) depuis les parois latérales de la tranchée (301).

9. Photodiode selon l'une quelconque des revendications 1 à 8, comprenant en outre, du côté de la face arrière du substrat (101), une couche (109) de même type de conductivité que le substrat mais de niveau de dopage supérieur.

10. Photodiode selon l'une quelconque des revendications 1 à 9, comportant en outre un circuit d'application d'une tension de polarisation entre les première (103) et deuxième (105) régions, ladite tension étant supérieure à la tension d'avalanche de la photodiode et étant telle que la zone d'avalanche de la photodiode soit localisée en regard de la partie centrale (103a) de la première région (103) et ne s'étende pas en regard de la partie périphérique (103b) de la première région.

## Patentansprüche

1. SPAD-Typ-Fotodiode (200; 300), die in einem Halbleitersubstrat (101) eines ersten Leitfähigkeitstyps Folgendes aufweist:
einen ersten Bereich (103) eines zweiten Leitfähigkeitstyps, der sich von der Oberseite des Substrats erstreckt;
einen zweiten Bereich (105) des ersten Leitfähigkeitstyps, der ein größeres Dotierungsniveau besitzt als das Substrat, der sich von der Unterseite des ersten Bereichs (103) erstreckt, wobei der zweite Bereich (105) in der Draufsicht einen Oberflächenbereich besitzt, der kleiner ist als der des ersten Bereichs (103) und der gegenüber einem Mitteltteil (103a) des ersten Bereichs angeordnet ist;
einen dritten Bereich (201; 301) des ersten Leitfähigkeitstyps, der ein Dotierungsniveau besitzt, das größer ist als das des Substrats, der sich von der Oberseite des Substrats erstreckt, wobei der dritte Bereich (201; 301) den ersten Bereich (103) seitlich umgibt; und
einen vierten, verdeckten Bereich (203) des ersten Leitfähigkeitstyps, der ein Dotierungsniveau besitzt, das größer ist als das des Substrats, der einen Umfangsring bildet, der den zweiten Bereich (105) mit den dritten Bereich (201; 301) verbindet, so dass die Seitenflächen und die Unterseite des ersten Bereichs (103) vollständig von der Anordnung, die von dem zweiten, dritten und vierten Bereich gebildet wird, umgeben sind.

2. Fotodiode (200; 300) nach Anspruch 1, wobei das Dotierungsniveau des Substrats (101) kleiner als 5*10¹⁴ Atome/cm³ ist.

3. Fotodiode (200; 300) nach Anspruch 1 oder 2, wobei das Dotierungsniveau des dritten Bereichs (201; 301) größer oder gleich zu dem des zweiten Bereichs (105) ist.

4. Fotodiode (200; 300) nach einem der Ansprüche 1 bis 3, wobei die Dicken E105 und E203 der zweiten (105) und vierten (203) Bereiche und die Dotierungsniveaus C105 und C203 der zweiten (105) und vierten (203) Bereiche so sind, dass das Produkt E105*C105 im Wesentlichen gleich dem Produkt E203*C203 ist.

5. Fotodiode (200; 300) nach einem der Ansprüche 1 bis 4, wobei die dritten (201; 301) und vierten (203) Bereiche nicht in Kontakt mit dem ersten Bereich (103) sind.

6. Fotodiode (200) nach einem der Ansprüche 1 bis 5, wobei der dritte Bereich (201) ein implantierter oder diffundierter Bereich ist, der in dem Substrat (101) ausgebildet ist.

7. Fotodiode (300) nach einem der Ansprüche 1 bis 5, wobei der dritte Bereich (301) ein Graben ist, der mit dotiertem Polysilicium gefüllt ist.

8. Fotodiode (300) nach Anspruch 7, wobei sich ein Bereich (302) des gleichen Leitfähigkeitstyps wie das des Substrats (101) aber mit größerem Dotierungsniveau in das Substrat (101) von den Seitenwänden des Grabens (301) aus erstreckt.

9. Fotodiode nach einem der Ansprüche 1 bis 8, das ferner aufweist: auf der Rückseite des Substrats (101) eine Schicht (109) des gleichen Leitfähigkeitstyps wie das des Substrats aber mit einem größeren Dotierungsniveau.

10. Fotodiode nach einem der Ansprüche 1 bis 9, das ferner eine Schaltung zum Anlegen einer Vorspannung zwischen den ersten (103) und zweiten (105) Bereichen aufweist, wobei die Spannung größer ist als die Durchbruchspannung der Fotodiode und so ist, dass der Durchbruchsbereich der Fotodiode gegenüber dem Mittelteil (103a) des ersten Bereichs (103) angeordnet ist und sich nicht gegenüber dem Randteil (103b) des ersten Bereichs erstreckt.

## Claims

1. A SPAD-type photodiode (200; 300) comprising, in a semiconductor substrate (101) of a first conductivity type:
a first region (103) of the second conductivity type extending from the upper surface of the substrate;
a second region (105) of the first conductivity type having a greater doping level than the substrate, extending from the lower surface of the first region (103), the second region (105) having, in top view, a surface area smaller than that of the first region (103) and being located opposite a central portion (103a) of the first region;
a third region (201; 301) of the first conductivity type having a doping level greater than that of the substrate extending from the upper surface of the substrate, the third region (201; 301) laterally surrounding the first region (103); and
a fourth buried region (203) of the first conductivity type having a doping level greater than that of the substrate, forming a peripheral ring connecting the second region (105) to the third region (201; 301) so that the lateral surfaces and the lower surface of the first region (103) are totally surrounded by the assembly formed by the second, third, and fourth regions.

2. The photodiode (200; 300) of claim 1, wherein the doping level of the substrate (101) is smaller than 5*10¹⁴ atoms/cm³.

3. The photodiode (200; 300) of claim 1 or 2, wherein the doping level of the third region (201; 301) is greater than or equal to that of the second region (105).

4. The photodiode (200; 300) of any of claims 1 to 3, wherein thicknesses E105 and E203 of the second (105) and fourth (203) regions, and doping levels C105 and C203 of the second (105) and fourth (203) regions are such that product E105*C105 is substantially equal to product E203*C203.

5. The photodiode (200; 300) of any of claims 1 to 4, wherein the third (201; 301) and fourth (203) regions are not in contact with the first region (103).

6. The photodiode (200) of any of claims 1 to 5, wherein the third region (201) is an implanted or diffused region formed in the substrate (101).

7. The photodiode (300) of any of claims 1 to 5, wherein the third region (301) is a trench filled with doped polysilicon.

8. The photodiode (300) of claim 7, wherein a region (302) of the same conductivity type as the substrate (101) but of greater doping level extends in the substrate (101) from the lateral walls of the trench (301).

9. The photodiode of any of claims 1 to 8, further comprising, on the rear surface side of the substrate (101), a layer (109) of the same conductivity type as the substrate but of greater doping level.

10. The photodiode of any of claims 1 to 9, further comprising a circuit of application of a bias voltage between the first (103) and second (105) regions, said voltage being greater than the avalanche voltage of the photodiode and being such that the avalanche area of the photodiode is located opposite the central portion (103a) of the first region (103) and does not extend opposite the peripheral portion (103b) of the first region.
